# EUROPÄISCHE PATENTSCHRIFT

(11) **EP 1 366 371 B1**
(45) Veröffentlichungstag und Bekanntmachung des Hinweises auf die Patenterteilung: **02.11.2005**
(21) Anmeldenummer: 02703610.2
(22) Anmeldetag: 28.02.2002
(51) Int. Cl.: G01R 15/18, H01F 38/28

(54) **ÜBERTRAGER FÜR EINEN STROMSENSOR**
TRANSFORMER FOR A CURRENT SENSOR
TRANSFORMATEUR DESTINE A UN CAPTEUR DE COURANT

(30) Priorität: 05.03.2001 DE 10110475
(43) Veröffentlichungstag der Anmeldung: 03.12.2003
(73) Patentinhaber: Vacuumschmelze GmbH, 63450 Hanau (DE)
(72) Erfinder: SCHÄFER, Stefan, 55452 Rümmelsheim (DE)
(74) Vertreter: Schmuckermaier, Bernhard
(86) Internationale Anmeldenummer: PCT/EP2002/002191
(87) Internationale Veröffentlichungsnummer: WO 2002/071081

(56) Entgegenhaltungen:
- EP-A- 0 294 590
- EP-A- 0 538 578
- US-B1- 6 191 673

## Beschreibung

Die Erfindung betrifft einen Übertrager für einen Stromsensor.

Als.Übertrager ist dabei eine magnetische Anordnung im allgemeinen Sinne zu verstehen, die mit einem Primärleiter magnetisch und die mit einer Auswerteelektronik elektrisch gekoppelt ist. Auf diese Weise wird ein Stromsensor gebildet, der die Erfassung des Stromes in dem Primärleiter erlaubt, wobei eine Stromerfassung für Gleichstrom und Wechselstrom gleichermaßen möglich ist.

Es sind beispielsweise sogenannte Kompensationsstromsensoren bekannt, die einen ringförmigen Magnetkern mit Luftspalt aufweisen. Der Magnetkern ist mit einer Sekundärwicklung (Kompensationswicklung) versehen. Der Primärleiter, d.h. der Leiter, der den zumessenden Strom führt, ist zentral durch den Magnetkern geführt. Im Luftspalt des Kerns befindet sich eine Magnetfeldsonde, die den Fluss im Magnetkern erfasst. Das Signal der Sonde wird über eine Verstärkerschaltung der Sekundärwicklung (Kompensationswicklung) zugeführt derart, dass der durch den Primärleiter induzierte magnetische Fluss ständig zu Null kompensiert wird. Der Sekundärstrom, der hierfür benötigt wird, ist dann streng proportional zum zu messenden Primärstrom. Ausgehend von einem geradlinigen Primärleiter wird der Proportionalitätsfaktor durch die Windungszahl der Sekundärwicklung (Kompensationswicklung) bestimmt. Als Magnetfeldsensor wird häufig eine nach dem Hall-Prinzip arbeitende Sonde insbesondere ein entsprechender integrierter Schaltkreis eingesetzt. Im Falle eines derartigen Hall-Sonde ist der Luftspalt unbedingt erforderlich, da die Magnetfeldempfindlichkeit relativ gering ist. Die Feldkonzentration durch den Magnetkern ist also erforderlich, um eine genügend hohe Empfindlichkeit des Regelkreises zu gewährleisten.

Die Verwendung einer Hall-Sonde hat den Nachteil eines deutlichen Offsets, das bedeutet, dass die Ausgangsspannung ohne anliegendes Magnetfeld von Null verschieden ist. Ferner hat dieser Offset eine ausgeprägte Temperaturabhängigkeit. Dies führt nun zu einem deutlichen Offset mit ausgeprägter Temperaturabhängigkeit.

Des weiteren sind Kompensationsstromsensoren mit weichmagnetischer Magnetfeldsonde bekannt, wie sie beispielsweise in der EP 0 294 590 A2 beschrieben sind. Bei dieser Lösung wird ein geschlossener Magnetkern verwendet. Neben dem Magnetkern ist mindestens ein mit einer Indikatorwicklung versehenes streifenförmiges Element aus amorphem weichmagnetischem Material angeordnet. Dieses Element dient dann als Magnetfeldsonde. Zur Auswertung wird es mit Hilfe einer Indikatorwicklung pulsförmig bipolar magnetisiert und die Unsymmetrie der Strom- bzw. der Spannungsamplituden zur Ermittlung und Auswertung des Fehlabgleiches benutzt. Diese Anordnung hat gegenüber der Anordnung mit Hall-Sonde den Vorteil, dass die Hysterese dieser Sonde verschwindend gering ist. Das führt beim Kompensationsstromssensor zu einem sehr kleinen Offset. Außerdem ist die Temperaturdrift einer derartigen Sonde in den meisten Fällen vernachlässigbar, so dass der Offset darüber hinaus auch temperaturstabil ist.

Die zuletzt genannte Anordnung hat jedoch den Nachteil, dass die Magnetfeldsonde das Feld des Primärleiters, d.h. das Feld im Luftraum, erfasst. Eine Flusskonzentration durch den Magnetkern findet nicht statt. Da es sich bei der Magnetfeldsonde um ein streifenförmiges Element handelt, ist die effektive Permeabilität des Magnetkerns der Sonde infolge der starken Scherung des magnetischen Kreises relativ gering. Das führt insgesamt zu einer mäßigen Empfindlichkeit der Magnetfeldsonde. Eine geringe Empfindlichkeit der Magnetfeldsonde führt aber zu einer geringen Verstärkung in der ersten Stufe des Regelkreises, so dass sich ein Offset der beteiligten Verstärker als Offset des gesamten Stromsensors bemerkbar macht.

Um diesen Nachteil zu vermeiden, wird bei der EP 0 294 590 A2 ein Luftspalt in den Magnetkern eingefügt. Dieser Luftspalt sorgt für eine Flusskonzentration am Ort der Sonde und damit zu einer höheren Empfindlichkeit der gesamten Anordnung. Damit,ist der erste Nachteil der Anordnung ausgeschaltet.

Ein zweiter Nachteil dieser Anordnung liegt jedoch in einer gewissen Fremdfeldempfindlichkeit. Die Magnetfeldsonde bzw. die Magnetfeldsonden können genauso wie das Feld des Primärleiters und das der Kompensationsspule auch externe Magnetfelder nachweisen. Bei Einsatz von zwei Magnetfeldsonden kompensiert sich ein äußeres Feld, da die Sonden gegensinnig gepolt sind. Dies gilt aber nur bei einem vollständig homogenen äußeren Magnetfeld. Ein solches Magnetfeld ist aber in der Praxis in den seltensten Fällen gegeben, da äußere Magnetfelder von benachbarten Stromleitern oder beispielsweise Transformatoren ausgehen, die ein stark inhomogenes Magnetfeld ausstrahlen.

Ein dritter Nachteil, der in der EP 0 294 590 A2 offenbarten Anordnung ist die Abhängigkeit von der Lage des Primärleiters. Eine hohe Genauigkeit hat diese Anordnung nur dann, wenn ein idealisiert unendlich langer Leiter exakt auf der Achse des Magnetkerns durch diesen geführt wird. Nur dann werden die Sonden genauso wie der Magnetkern durchflutet, so dass die strenge Proportionalität zwischen dem Sekundär- und dem Primärstrom gilt. Wird zum Beispiel der Primärleiter als Schlaufe über ein Ringsegment des Magnetkerns geführt, so wird an dieser Stelle ein sehr hoher Fluss in den Magnetkern eingespeist, während das H-Feld am Ort der Sonden deutlich geringer wird als bei der axialen Durchführung des Primärleiters. In diesem Fall wird der Sensor zwar immer noch ein stromlineares Ausgangssignal liefern, jedoch ist dessen Steigung wesentlich geringer als bei optimaler Auslegung und dessen Messbereich fällt wegen Sättigungseffekten im Magnetkern auch wesentlich geringer aus.

Diese Nachteile werden durch weitere im Stand der Technik beschriebene Maßnahmen ausgeglichen. Zu diesen Maßnahmen zählen die spezielle Bewicklung des Sensorstreifens (wie in der EP 0 538 578 beschrieben), die spezielle Form des gestapelten Magnetkerns (wie aus der EP 0 510 376 bekannt), die Verwendung eines Biegekerns (wie in der DE 197 20 010.9 offenbart) und eine enge Kopplung zwischen Primärseite und Sekundärseite (entsprechend beispielsweise der DE 197 05 770.8).

Ausgehend von der in der EP 0 294 590 A2 beschriebenen Anordnung sei für die folgenden Betrachtungen nur eine einzige Magnetfeldsonde vorausgesetzt. Der Luftspalt wird beibehalten, um eine ausreichende Empfindlichkeit der Magnetfeldsonde zu gewährleisten. Die Magnetfeldsonde ist jedoch in den Luftspalt des Magnetkerns bzw. in eine Tasche des Magnetkerns eingebracht. Dadurch wird zum einen die Fremdfeldempfindlichkeit erheblich reduziert, da der Magnetkern abschirmend wirkt. Zum anderen wird eine Abhängigkeit von der Lage des Primärleiters vermieden, da jeder vom Primärleiter in den Magnetkern eingespeiste Fluss, die Magnetfeldsonde durchdringen muss. Diese kostengünstig fertigbaren Stromsensoren nach dem Stand der Technik zeichnen sich damit durch die folgenden Eigenschaften aus:
1. Sie haben einen deutlich geringeren Offset als vergleichbare Stromsensoren mit Hall-Magnetfeldsonden, da die Magnetfeldsonde keine Hysterese aufweist.
2. Sie haben eine geringere Fremdfeldempfindlichkeit.
3. Sie weisen nur eine sehr geringe Abhängigkeit von der Lage des Primärleiters auf.
4. Der Sensor ist sehr kostengünstig fertigbar, da der Magnetkern aus zwei Stanz-/Biegeteilen besteht und die Kompensationsspule aus einer einfachen Kastenwicklung besteht.

Andererseits sind aber auch mit derartigen Ausführungsformen Nachteile verbunden. So sitzt die Magnetfeldsonde im Luftspalt des Magnetkerns. Sie wird damit durch die Remanenz des Magnetkerns beeinflusst. Kostengünstig herstellbare Magnetkerne aus Nickel-/Eisenmaterial weisen eine gewisse Koerzitivfeldstärke auf, die zu einem einen remanenten Magnetfluss auch ohne äußere Aussteuerung führt. Die Enden des Magnetkerns im Luftspalt wirken wie Polflächen, d.h., dass auch ohne Aussteuerung hier ein gewisses Feld existiert, das die Magnetfeldsonde beeinflusst. Dies führt zu einem Offset des Stromsensors. Dieser Offset ist deutlich geringer als bei Stromsensoren mit Hall-Magnetfeldsonde, kann aber in gewissen Anwendungsfällen immer noch störend in Erscheinung treten. Bezüglich des Primärstromes liegt er in etwa in der Größenordnung von 50 bis 100 mA. Ein solcher Offset bedeutet eine Begrenzung des Messbereiches nach unten, da Ströme, die in der Größenordnung des Offsets liegen, nicht mehr exakt erfasst werden können.

Ein weiterer Nachteil der bekannten Anordnung ergibt sich aus der Tatsache, dass die Sekundärspule nur auf einem Sektor des Magnetkerns im Bereich der Magnetfeldsonde angebracht ist. Der Magnetfluss der Sekundärspule schließt sich nicht ausschließlich über den Magnetkern, sondern auch als Streufluss im Raum. Dieser Streufluss fehlt in den Bereichen des Magnetkernes außerhalb der Kompensationsspule zur Kompensation des durch den Primärleiter induzierten Flusses. Außerhalb der Kompensationsspule wird der Magnetkern daher proportional zur Stärke des Primärstromes ausgesteuert. Ab einem gewissen Primärstrom wird die Sättigungsflussdichte des Magnetkerns erreicht und der Magnetkern partiell gesättigt. Ab diesem Punkt wird der Stromsensor stark nichtlinear, d.h., dieser Effekt begrenzt den Messbereich des Stromsensors nach oben.

Aufgabe der Erfindung ist es daher, einen Stromsensor anzugeben, der zum einen die oben geschilderte Sättigungsproblematik vermeidet und zum anderen einen extrem geringen Offset aufweist.

Die Aufgabe wird gelöst durch einen Übertrager gemäß Patentanspruch 1. Ausgestaltungen und Weiterbildungen des Erfindungsgedankens sind Gegenstand von Unteransprüchen.

Erfindungsgemäße Übertrager zeichnen sich durch einen sehr großen Messbereich aus, wobei damit aufgebaute Stromsensoren dennoch kompakt und von ihrer konstruktiven Ausführung her einfach und kostengünstig zu gestalten sind. Sie haben insbesondere einen deutlich geringeren Offset als vergleichbare Stromsensoren mit Hall-Magnetfeldsonden, da die Magnetfeldsonde keine Hysterese aufweist. Sie haben zudem eine geringere Fremdfeldempfindlichkeit und weisen nur eine sehr geringe Abhängigkeit von der Lage des Primärleiters auf. Der Sensor ist schließlich sehr kostengünstig fertigbar, da der Magnetkern aus zwei Stanz-/Biegeteilen und die Kompensationsspule aus einer einfachen Kastenwicklung bestehen kann.

Erreicht wird dies im einzelnen durch einen Übertrager mit einem geschlossenen Sondenkern aus weichmagnetischem Material, einer Sondenwicklung, die zu mindestens Abschnittsweise um den Sondenkern gewickelt ist, einem geschlossenen Kompensationskern aus weichmagnetischem Material, und einer Kompensationswicklung, die zumindest Abschnittsweise um Sondenkern und Kompensationskern gewickelt ist, wobei Sondenkern und Kompensationskern relativ zueinander derart angeordnet sind, dass ein dem Messstrom führender Leiter durch Sondenkern und Kompensationskern hindurchführbar ist. Dabei kann die Sondenwicklung und/oder die Kompensationswicklung nur teilweise oder bevorzugt vollständig um den gesamten Kernumfang herum gewickelt werden. Durch die vollständige Bewicklung wird eine symmetrische, streufeldarme Verteilung des Magnetfeldes erzielt.

Darüber hinaus kann als weichmagnetisches Material vorzugsweise beim Sondenkern, aber auch beim Kompensationskern oder bei beiden amorphes Metall bzw. nanokristallines Metall vorgesehen werden.

Bevorzugt werden Sondenkern und Kompensationskern als (runde) Ringkerne ausgebildet, wobei Sondenkern und Kompensationskern konzentrisch zueinander angeordnet sind. Weiterhin kann vorgesehen werden, dass der Sondenkern eine erheblich kleinere Querschnittsfläche als der Kompensationskern aufweist.

Bei einer Weiterbildung der Erfindung ist ein weiterer geschlossener Kompensationskern vorgesehen, wobei die Sondenwicklung zumindest abschnittsweise nur um den Sondenkern gewickelt ist und die Kompensationswicklung zumindest abschnittsweise um Sondenkern und beide Kompensationskerne gewickelt ist. Dabei wird bevorzugt der Sondenkern zwischen den beiden Kompensationskernen angeordnet. Auf diese Weise wird eine optimale Abschirmung von Kompensationskern und Kompensationswicklung und damit eine weitgehende Abschirmung vor Störfeldern erzielt.

Die Erfindung wird nachfolgend anhand der in den Figuren der Zeichnung dargestellten Ausführungsbeispiele näher erläutert. Es zeigt:
- Figur 1: ein erstes Ausführungsbeispiel eines erfindungsgemäßen Übertragers mit einem Kompensationskern in einer Anwendung bei einer allgemeinen Ausführungsform eines Stromsensors,
- Figur 2: den Übertrager nach Figur 1 im Querschnitt,
- Figur 3:: eine zweite Ausführungsform eines erfindungsgemäßen Übertragers mit zwei Kompensationskernen in Verbindung mit einer speziellen Ausführungsform eines Stromsensors und
- Figur 4: den Übertrager nach Figur 3 im Querschnitt.

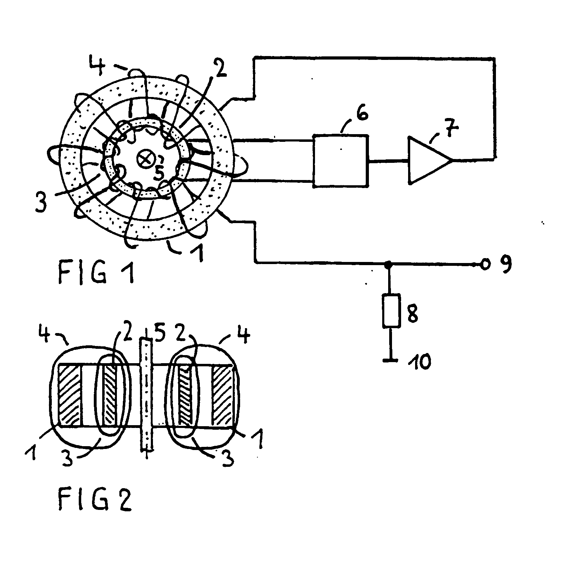

Bei den in Figur 1 gezeigten Anwendungsfall wird ein erfindungsgemäßer Übertrager mit einem geschlossenen Kompensationskern 1 und einem geschlossenen Sondenkern 2 vorgesehen. Obwohl beide Kerne eine beliebige geschlossene Form (quadratisch, rechteckig, oval etc.) annehmen können, wurde bevorzugt die Ringform (Kreisform) gewählt, da diese am einfachsten herzustellen ist und in diesem Zusammenhang die besten Eigenschaften aufweist. Der Sondenkern ist dabei von kleinerem Durchmesser als der Kompensationskern und folglich im Innenraum des Kompensationskerns 1 angeordnet. Zwar wäre auch in gleicher Weise eine Platzierung des Sondenkerns im Außenraum des Kompensationskernes oder über dem Kompensationskern möglich, jedoch ist die Anordnung im Innenraum im Hinblick auf die Abschirmung von äußeren Störfeldern auf den Sondenkern 2 günstiger.

Um den Sondenkern 2 ist eine Sondenwicklung 3 über den gesamten Umfang des Sondenkern 2 gewickelt. Das vollständige Umwickeln des Sondenkerns 2 hat den Vorteil, dass die Empfindlichkeit der Anordnung von Sondenkern 2 und Sondenwicklung 3 ortsunabhängig ist. Darüber hinaus ist eine Kompensationswicklung 4 vorgesehen, die ebenfalls aus den gleichen Gründen um den gesamten Umfang von Kompensationskern 1 und Sondenkern 2 gewickelt ist. Im Innenraum des Sondenkerns 2 und damit auch im Innenraum des Kompensationskerns 1 befindet sich schließlich ein den zu messenden Strom führender Leiter 5. Durch die geschlossene Ausführung von Sondenkern und Kompensationskern, sowie insbesondere die spezielle Anordnung beider wird erreicht, dass das gemessene Feld und damit der gemessene Strom unabhängig ist von der Lage des Leiters 5 im Innenraum von Sondenkern 2 und Kompensationskern 1.

Die in Figur 1 als Ausführungsbeispiel nur schematisch dargestellte Auswerteschaltung besteht aus einer Symmetriestufe 6 sowie einer dieser nachgeschalteten Verstärkerstufe 7. Die Symmetriestufe 6 ist eingangsseitig mit der Sondenwicklung 3 gekoppelt. Über die Symmetriestufe 6 wird der Sondenkern 2 bipolar magnetisiert. Aus der Unsymmetrie der zeitlichen Strom- bzw. Spannungsverläufe wird in dieser Stufe ein Ausgangssignal erzeugt, welches in der Verstärkerstufe 7 verstärkt wird und zur Ansteuerung der Kompensationswicklung 4 dient.

Der Ausgangsstrom der Verstärkerstufe 7 wird über einen (beispielsweise auf Massepotential 10 führenden) Widerstand 8 in die Kompensationsspule eingespeist. Im eingeregelten Zustand kompensiert das Feld dieses Stromes im Kompensationskern 1 sowie im Sondenkern 2 den magnetischen Fluss des Primärleiters 5. Dann ist der Ausgangsstrom der Verstärkerstufe 7 und damit der Spannungsabfall über dem Widerstand 8 proportional zum im Primärleiter 5 fließenden Primärstrom.

In Figur 2 ist der Aufbau des erfindungsgemäßen Übertragers nach Figur 1 im Querschnitt dargestellt. Zu ersehen ist dabei, dass Kompensationskern 1 und Sondenkern 2 unterschiedliche Querschnitte aufweisen. In den Zwischenraum zwischen Kompensationskern 1 und Sondenkern 2 ist ein Teil der Sondenwicklung 3 untergebracht. Um Kompensationskern 1, Sondenkern 2 und Sondenwicklung 3 ist schließlich die Kompensationswicklung 4 herumgewickelt.

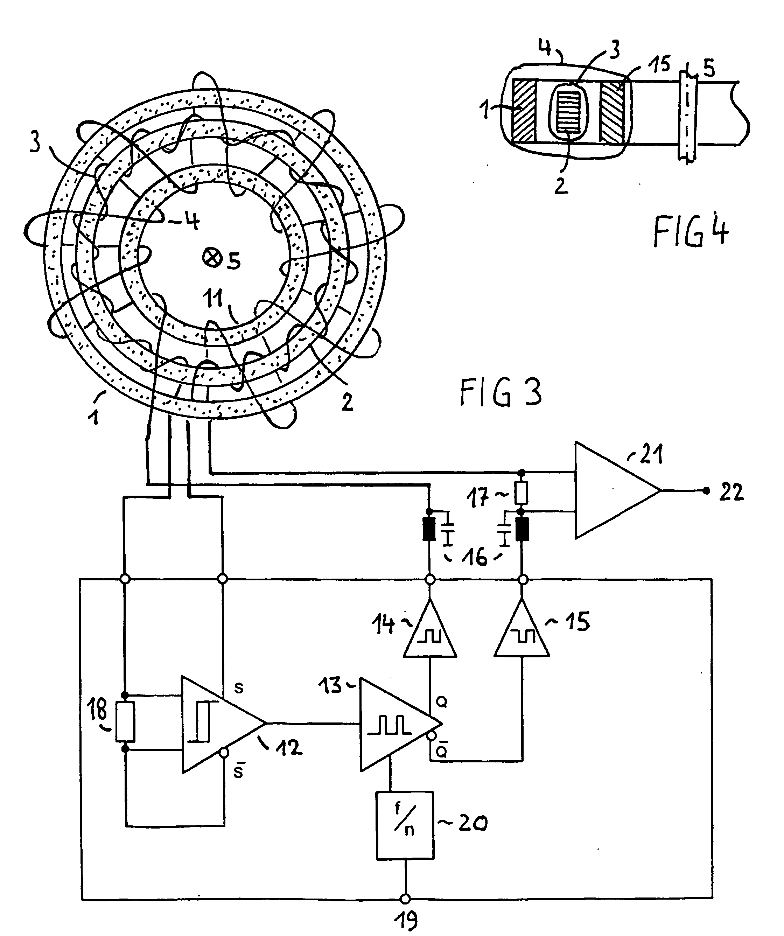

Eine andere Ausführungsform des erfindungsgemäßen Übertragers in Verbindung mit einer im Detail dargestellten Auswerteschaltung ist in Figur 3 gezeigt. Gegenüber dem Ausführungsbeispiel nach Figur 1 ist der Übertrager nach Figur 3 dahingehend erweitert, dass ein zusätzlicher Kompensationskern 11 in dem Innenraum des Sondenkerns 2 und damit im Innenraum des Kompensationskerns 1 angeordnet ist. Der weitere Kompensationskern 11 ist dabei zwischen dem Sondenkern 2 und dem Leiter 5 platziert. Während die Sondenwicklung 2 gegenüber dem Ausführungsbeispiel nach Figur 1 unverändert bleibt, ist die Kompensationswicklung 4 um Sondenkern 2, Sondenwicklung 3 sowie die beiden Kompensationskerne 1 und 11 gewickelt.

Die nachfolgende Auswerteschaltung besteht aus einer Symmetriestufe 12 sowie einer dieser nachgeschalteten Pulsweitenverstärker 13. Die Symmetriestufe 12 ist eingangsseitig mit der Sondenwicklung 3 gekoppelt. Über die Symmetriestufe 12 wird der Sondenkern 2 bipolar magnetisiert. Der Unsymmetrie der zeitlichen Strom- bzw. Spannungsverläufe entsprechend wird in dieser Stufe ein Ausgangssignal erzeugt, welches den nachgeschalteten Pulsweitenverstärker 13 ansteuert, dessen symmetrisches Ausgangssignal unter Zwischenschaltung zweier Treiberstufen 14, 15, einer (symmetrischen) Filterstufe 16 und eines Widerstands 17 seinerseits zur Ansteuerung der Kompensationswicklung 4 dient. Im eingeregelten Zustand kompensiert wiederum das Feld dieses Stromes im Kompensationskern 1 sowie im Sondenkern 2 den magnetischen Fluss des Primärleiters 5. Dann ist der vom Pulsweitenverstärker 13 erzeugte Ausgangsstrom und damit der Spannungsabfall über dem Widerstand 17 proportional zu dem im Primärleiter 5 fließenden Primärstrom.

Die.Symmetriestufe 12 kann beispielsweise einen Schmitt-Trigger mit symmetrischem Eingang und symmetrischem Ausgang aufweisen, wobei der Ausgang zur Ansteuerung der Sondenwicklung 3 vorgesehen ist. Die vom Ausgang des Schmitt-Triggers an die Sondenwicklung 3 angelegte Spannung erzeugt in der Sondenwicklung 3 einen Strom, der zudem vom zusätzlichen, von Kompensationswicklung 4 und Primärleiter 5 erzeugten Fluss im Sondenkern 2 beeinflusst wird. Der Strom wird vom Eingang des Schmitt-Triggers mittels eines Widerstands 18 wiederum erfasst. Ein pulsweitenmoduliertes Signal am Ausgang der Symmetriestufe 12 gibt dann die Unsymmetrie zwischen Eingangs- und Ausgangssignal am Schmitt-Trigger und damit die Unsymmetrie zwischen Strom und Spannung an der Sondenwicklung 3 wieder. Dieses Pulsweitensignal wird dann vom Pulsweitenverstärker 13 aufbereitet. Der Pulsweitenverstärker 13 wird dazu von einer externen Taktsignalquelle 19 über einen Frequenzteiler 20 getaktet.

Schließlich wird die Spannung über dem Widerstand 17, die dem im Primärleiter 5 fließenden Strom proportional ist, mittels eines Differenzverstärkers 21 abgenommen und steht dann als Ausgangsspannung 22 (oder Ausgangsstrom) zur Verfügung.

Als Kernmaterial für den Sondenkern 2 wird bei dem Ausführungsbeispiel nach Figur 1 nanokristallines Material vorgesehen, während beim Ausführungsbeispiel nach Figur 2 amorphes Metall verwendet wird (oder umgekehrt). Als Kernmaterial für den Kompensationskern 4 wird dagegen in beiden Fällen NiFe-Material benutzt.

In Figur 4 ist der Querschnitt eines Teils des Übertragers nach Figur 3 gezeigt. Die beiden Kompensationskerne 1 und 11 flankieren dabei den Sondenkern 2 zu beiden Seiten in radialer Richtung der drei Kerne. Dabei ist die Querschnittsfläche des Sondenkerns 2 kleiner als die Querschnittsfläche eines jeden der beiden Kompensationskerne 1, 11, die beim Ausführungsbeispiel die gleiche Querschnittsfläche aufweisen. Darüber hinaus ist die Höhe des Sondenkerns 2 geringer als die Höhe der beiden Kompensationskerne 1, 11.

Die Sondenwicklung 3 ist dabei so angeordnet, dass sie maximal die Höhe der beiden Kompensationskerne 1 und 11 erreicht. Um die Kompensationskerne 1, 11, den Sondenkern 2 sowie die Sondenwicklung 3 herumgewickelt ist schließlich die Kompensationswicklung 4. Da der zweite Querschnitt identisch zum ersten ist, wurde in der Zeichnung der Übertrager lediglich hälftig dargestellt.

Als Magnetfeldsonde wird also bei den gezeigten Ausführungsbeispielen ein geschlossener, vorzugsweise ringförmiger Magnetkern aus amorphen oder nanokristallinen Metall verwendet. Der Ringkern ist mit einer Wicklung versehen, die vorzugsweise symmetrisch, den gesamten Kern umschließt. Mit Hilfe der Wicklung wird der Magnetkern periodisch oder impulsförmig bipolar magnetisiert und die Unsymmetrie der Strom- bzw. der Spannungsamplituden wird zur Auswertung des Fehlabgleiches benutzt.

Ein zweiter geschlossener, vorzugsweise ringförmiger Magnetkern wird in der Ebene des Sondenkerns vorzugsweise konzentrisch mit dem Sondenkern angeordnet. Beide Kerne sowie die Wicklung des Sondenkerns werden von der Sekundärwicklung umschlossen. Der Primärleiter ist durch die Öffnungen beider Kerne geführt. Durch die Auswerteschaltung wird in die Kompensationswicklung ein Strom eingespeist, der in beiden Kernen zu jeder Zeit den magnetischen Fluss des Primärleiters kompensiert. Der Kompensationsstrom ist damit proportional zum Primärstrom.

Bei einer Anordnung wie beispielsweise in Figur 1 oder 3 gezeigt kann ein Primärstrom auch ohne Erzeugung eines Kompensationsstromes über die Kompensationswicklung gemessen werden. Bei kleinen Primärströmen erhält man mit einer entsprechend ausgelegten Symmetriestufe ein proportionales, annähernd offsetfreies Ausgangssignal, wenn über ein Steuersignal die Treiberstufe(n) (Verstärkerstufe) hochohmig geschaltet werden. Der Stromsensor bietet somit die Möglichkeit einer Strommessbereichsumschaltung.

Bei kleinen Strömen kann durch große lineare Verstärkung der Symmetriestufe mit dem Ausgangssignal dieser Stufe unter Umständen sehr genau gemessen werden. Überschreitet der Primärstrom eine festgelegte Schwelle, so kann die Verstärkerstufe (z. B. 7) zugeschaltet werden. Der Sensor misst dann als Kompensationsstromsensor sehr große Primärströme. Ein derartiger Stromsensor besitzt einen extrem großen Dynamikbereich.

## Patentansprüche

1. Übertrager für einen Stromsensor mit
einem geschlossenen Sondenkern (2) aus weichmagnetischem Material,
einer Sondenwicklung (3), die zumindest abschnittsweise um den Sondenkern (2) gewickelt ist,
einem geschlossenen Kompensationskern (1) aus weichmagnetischem Material,
einer Kompensationswicklung (4), die zumindest abschnittsweise um Sondenkern (2) und Kompensationskern (4) gewickelt ist, wobei
Sondenkern (2) und Kompensationskern (4) relativ zueinander derart angeordnet sind, dass
ein den Messstrom führender Leiter (5) durch Sondenkern (2) und Kompensationskern (1) hindurchführbar ist.

2. Übertrager nach Anspruch 1, bei dem der Sondenkern (2) über den gesamten Umfang gleichmäßig von der Sondenwicklung (3) umwickelt ist.

3. Übertrager nach Anspruch 1 oder 2, bei dem Sondenkern und Kompensationskern (1) über den gesamten Umfang gleichmäßig von der Kompensationswicklung (4) umwickelt ist.

4. Übertrager nach einem der Ansprüche 1 bis 3, bei dem als weichmagnetisches Material des Sondenkerns (2) amorphes Metall vorgesehen ist.

5. Übertrager nach einem der Ansprüche 1 bis 3, bei dem als weichmagnetisches Material des Sondenkerns (2) nanokristallines Metall vorgesehen ist.

6. Übertrager nach einem der Ansprüche 1 bis 5, bei dem Sondenkern (2) und Kompensationskern (1) als Ringkerne ausgebildet sind und
Sondenkern (2) und Kompensationskern (1) konzentrisch zueinander angeordnet sind.

7. Übertrager nach einem der Ansprüche 1 bis 6, bei dem der Sondenkern (2) eine kleinere Querschnittsfläche als der Kompensationskern (1) aufweist.

8. Übertrager nach einem der Ansprüche 1 bis 7, bei dem ein weiterer geschlossener Kompensationskern (11) vorgesehen ist, wobei die Sondenwicklung (3) zumindest abschnittsweise um den Sondenkern (2) gewickelt ist und die Kompensationswicklung (4) zumindest abschnittsweise um Sondenkern (2) und beide Kompensationskerne (1, 15) gewickelt ist.

9. Übertrager nach Anspruch 8, bei dem der Sondenkern (2) zwischen den beiden Kompensationskernen (1, 11) angeordnet ist.

## Claims

1. Transformer for a current sensor, comprising a closed probe core (2) of soft-magnetic material, a probe winding (3) wound around the probe core (2) at least in sections, a closed compensating core (1) of soft-magnetic material and a compensating winding (4) wound around the probe core (2) and the compensating core (4) at least in sections, the probe core (2) and the compensating core (4) being arranged in such a manner relative to one another that a conductor (5) carrying the measuring current can be passed through the probe core (2) and the compensating core (1).

2. Transformer according to claim 1, in which the probe winding (3) is wound in a uniform manner around the entire circumference of the probe core (2).

3. Transformer according to claim 1 or claim 2, in which the compensating winding (4) is wound in a uniform manner around the entire circumference of the probe core and the compensating core (1).

4. Transformer according to one of claims 1 to 3, in which amorphous metal is provided as the soft-magnetic material of the probe core (2).

5. Transformer according to one of claims 1 to 3, in which nanocrystalline metal is provided as the soft-magnetic material of the probe core (2).

6. Transformer according to one of claims 1 to 5, in which the probe core (2) and the compensating core (1) are designed as toroidal cores and the probe core (2) and the compensating core (1) are arranged concentrically with one another.

7. Transformer according to one of claims 1 to 6, in which the probe core (2) has a smaller cross-sectional area than the compensating core (1).

8. Transformer according to one of claims 1 to 7, in which another closed compensating core (11) is provided, the probe winding (3) being wound around the probe core (2) at least in sections and the compensating winding (4) being wound around the probe core (2) and the two compensating cores (1, 11) at least in sections.

9. Transformer according to claim 8, in which the probe core (2) is arranged between the two compensating cores (1, 11).

## Revendications

1. Transformateur pour un capteur de courant comprenant
un noyau de sonde fermé (2) en matière à magnétisme doux,
un enroulement de sonde (3) bobiné, au moins par segments, autour du noyau de sonde (2),
un noyau de compensation fermé (1) en matière à magnétisme doux,
un enroulement de compensation (4) bobiné, au moins par segments, autour du noyau de sonde (2) et du noyau de compensation (4),
dans lequel
le noyau de sonde (2) et le noyau de compensation (4) sont disposés l'un par rapport à l'autre de telle manière qu'un conducteur (5) qui conduit le courant de mesure puisse être enfilé à travers le noyau de sonde (2) et le noyau de compensation (1).

2. Transformateur selon la revendication 1,
**caractérisé en ce que**
le noyau de sonde (2) est entouré uniformément sur toute sa périphérie par l'enroulement de sonde (3).

3. Transformateur selon la revendication 1 ou 2,
**caractérisé en ce que**
le noyau de sonde (2) et le noyau de compensation (1) sont entourés uniformément sur toute la périphérie par l'enroulement de compensation (4).

4. Transformateur selon une des revendications 1 à 3,
**caractérisé en ce que**
comme matière à magnétisme doux pour le noyau de sonde (2), on prévoit un métal amorphe.

5. Transformateur selon une des revendications 1 à 3,
**caractérisé en ce que**
comme matière à magnétisme doux pour le noyau de sonde (2), on prévoit un métal nanocristallin.

6. Transformateur selon une des revendications 1 à 5,
**caractérisé en ce que**
le noyau de sonde (2) et le noyau de compensation (1) sont constitués par des noyaux annulaires et le noyau de sonde (2) et le noyau de compensation (1) sont disposés concentriquement entre eux.

7. Transformateur selon une des revendications 1 à 6,
**caractérisé en ce que**
le noyau de sonde (2) présente une plus petite surface de section que le noyau de compensation (1).

8. Transformateur selon une des revendications 1 à 7,
**caractérisé par**
un autre noyau de compensation fermé (11), l'enroulement de sonde (3) étant bobiné au moins par segments autour du noyau de sonde (2), et l'enroulement de compensation (4) étant bobiné au moins par segments autour du noyau de sonde (2) et des deux noyaux de compensation (1, 11).

9. Transformateur selon la revendication 8,
**caractérisé en ce que**
le noyau de sonde (2) est disposé entre les deux noyaux de compensation (1, 11).
